# EUROPEAN PATENT SPECIFICATION

(11) **EP 1 989 780 B1**
(45) Date of publication and mention of the grant of the patent: **20.01.2010**
(21) Application number: 07704566.4
(22) Date of filing: 13.02.2007
(51) Int. Cl.: H03K 19/173, H03K 17/00

(54) **INTEGRATED CIRCUIT**
INTEGRIERTE SCHALTUNG
CIRCUIT INTÉGRÉ

(30) Priority: 13.02.2006 DE 102006006541
(43) Date of publication of application: 12.11.2008
(73) Proprietor: TEXAS INSTRUMENTS DEUTSCHLAND GMBH, 85356 Freising (DE)
(72) Inventor: JUNGERT, Horst, 84172 Buch Am Erlbach (DE); ELMER, Werner, 85368 Moosburg (DE)
(74) Representative: Holt, Michael
(86) International application number: PCT/EP2007/051394
(87) International publication number: WO 2007/093598

(56) References cited:
- US-B1- 6 271 692
- US-B1- 6 573 751
- MCADAMS H ET AL: "A 1-MBIT CMOS DYNAMIC RAM WITH DESIGN-FOR TEST FUNCTIONS" IEEE JOURNAL OF SOLID-STATE CIRCUITS, IEEE SERVICE CENTER, PISCATAWAY, NJ, US, vol. SC-21, no. 5, 1 October 1986 (1986-10-01), pages 635-642, XP000098226 ISSN: 0018-9200

## Description

### FIELD OF THE INVENTION

The invention relates to an integrated circuit for operation at a specified maximum supply voltage.

### BACKGROUND

Integrated circuits sometimes need to be switched to a special operating mode, such as a test mode. Switching a circuit to a particular mode of operation is conventionally done by providing a dedicated mode selection pin on the integrated circuit and applying a mode control signal to that pin. US-B-6 573 751 discloses a circuit using multiple voltages on one input pin to select between different modes.

### SUMMARY

The invention provides an integrated circuit that can be switched to a particular operating mode even when a dedicated mode selection pin is not available for some reason.

Specifically, in a described embodiment, the invention provides an integrated circuit for operation at a specified maximum supply voltage that comprises first and second supply terminals, a first signal input for application of a regular input signal, a second signal input and an output. The described integrated circuit embodiment further comprises a multiplexer with first and second inputs connected to the first and second signal inputs, respectively, for selectively switching either of the first and second signal inputs to the output under control of a selection signal. A gate circuit provides the selection signal to the multiplexer. The input of the gate circuit is driven by control circuitry. Clamping means are provided that limit the voltage at the first input of the multiplexer. The control circuitry comprises voltage detection means for detecting a voltage at the first signal input that exceeds the specific maximum supply voltage by a limited amount and, in response, applying a drive signal to the input of said gate circuit.

With such a circuit design, a relatively high voltage can be applied to the first signal input instead of the regular input signal to switch the circuit to a particular operating mode such as a test mode. The relatively high voltage at the first signal input will be detected by the voltage detection means to activate the multiplexer to switch its output from the first to the second signal input. The second input can be connected to any external signal source, or to any node internal of the integrated circuit, depending on the particular application. Application of a relatively high voltage to the signal input of the integrated circuit is tolerable due to the provision of the clamping means that prevents an over-stress at the gate oxide of the input transistors.

In a specific embodiment, a 0.18 µm process technology is used and the maximum admitted supply voltage is 1.8 Volt. A voltage of , for example, one Volt in excess of the 1.8 Volt supply voltage, applied to the first signal input of the integrated circuit, would switch the circuit to the test mode by routing the second signal input to the output, without damage to the voltage-sensitive components of the circuit.

In a preferred embodiment of the invention, the camping means simply includes a resistor connected between the first signal input and the corresponding first input of the multiplexer, and a diode-connected MOS transistor connected between the first input of the multiplexer and the first supply terminal. This ensures a reliable clamping action even up to input voltages as high as 8V. For the voltage detection means, a preferred implementation is with just a few basic devices, such as MOS transistor and resistor structures.

### BRIEF DESCRIPTION OF THE DRAWINGS

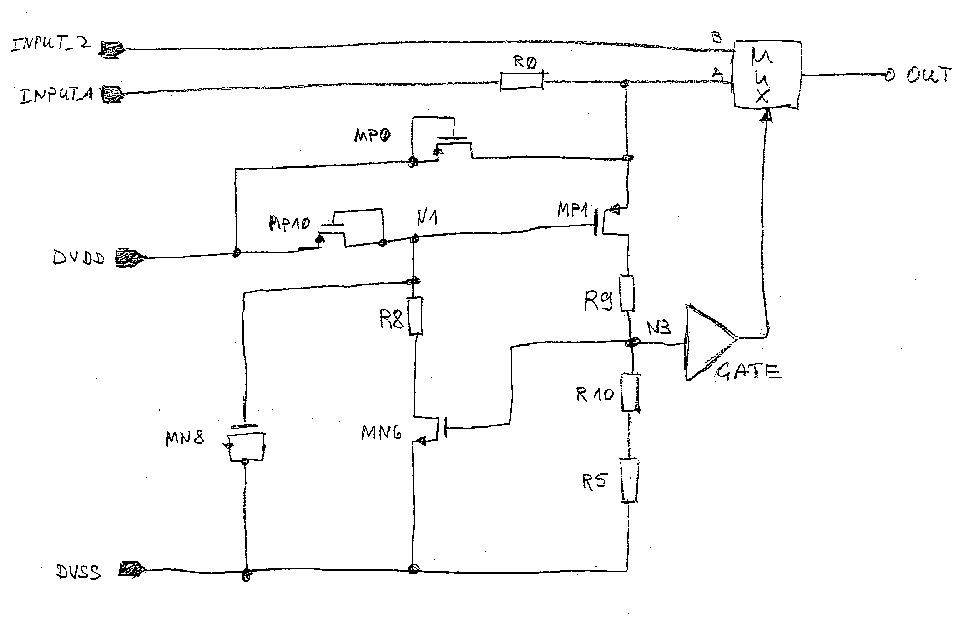

Further details of the invention will become apparent to those skilled in the art to which the invention relates, from the following description with reference to the appended drawing. The single figure of the drawing is a schematic circuit diagram of an example preferred implementation.

### DETAILED DESCRIPTION

With reference to the drawing, an input section of an integrated circuit is shown with two signal inputs INPUT_1 and INPUT_2, and two supply terminals DVDD and DVSS. The first signal input INPUT_1 is connected to a first input A of a multiplexer MUX through a resistor R0, and the second signal input INPUT 2 is directly connected to an input B of multiplexer MUX, which has an output OUT. A diode-connected PMOS transistor MP0 is connected between the input A of multiplexer MUX and supply terminal DVDD. Also connected between the input A of multiplexer MUX and supply terminal DVSS is a series circuit comprising a resistive divider with resistors R9, R10 and R5, and the a PMOS transistor MP1. The gate of PMOS transistor MP1 is shown connected to receive its bias from a diode-connected PMOS transistor MP10 connected to supply terminal DVDD. A series circuit of a resistor R8 and an NMOS transistor MN6 is connected between supply terminal DVSS and a connection node N1 of transistor MP 10 with the gate of transistor MP1. Transistor MN6 has its gate connected to a node N3 at the connection of resistors R9 and R10. Node N3 is also connected to the input of a gate circuit GATE, the output of which is connected to a control input of multiplexer MUX. An NMOS transistor MN8 is mounted as a gate-to-source/drain capacity and connected between node N1 and terminal DVSS to stabilize the voltage level at node N1.

The maximum allowed supply voltage of an integrated circuit depends on the process technology employed for its fabrication. Signal inputs to the circuit can accept voltage values slightly above the specified maximum voltage without damage to the gate oxide of the input stage transistors. For example, with a 0.18 µm technology, the specified maximum supply voltage is 1.8 Volt, and the voltage at the signal input may exceed that value by approximately 1 Volt. The integrated circuit can be operated in two modes. In a normal mode of operation, an input signal (analog or digital) is applied to signal input INPUT _1 at a voltage within the range of the specified maximum supply voltage. In this condition, transistor MP1 is off, the node N3 is substantially at the voltage level of terminal DVSS (normally the ground level) and the output of gate circuit GATE is low. A low output of the gate circuit controls the multiplexer MUX to connect its input A to its output OUT.

In a separate mode of operation which can be a test mode, for example, a voltage level in excess of the maximum specified supply voltage by a limited amount is applied to the signal input INPUT 1. If the voltage level at signal input INPUT _1 exceeds the supply voltage at terminal DVDD by a given amount of approx. 1 Volt in this example, transistor MP1 starts conducting, and node N3 is raised. As soon as the voltage level at node N3 reaches the threshold value of transistor MN6, the latter will start conducting, pulling down the level at node N1 and increasing the conductance of transistor MP1. Node N3 is raised to a stable logic state "HIGH" and gate circuit GATE changes its output to logic "HIGH," thereby controlling multiplexer MUX to connect the second signal input INPUT_2 to its output OUT.

The second signal input INPUT _2 can be connected to any external or internal signal source, as required by a particular application. With this concept, the circuit can be switched to a particular mode of operation without the requirement for a dedicated mode selection pin. The "mode switching voltage" applied to the first signal input INPUT_I can even be far in excess of the specified maximum supply voltage because the resistor R8 in conjunction with transistor MP0 constitutes an effective voltage clamping circuit that limits the voltage level at input A of multiplexer MUX to an acceptable amount. In the example disclosed, the voltage level at signal input INPUT _1 can be raised to a value as high as 8 Volt. Diode-connected transistor MP10 limits the voltage level at node N1 to DVDD less the diode voltage when transistor MN6 is conducting, thereby providing a well-defined gate voltage to transistor MP1. Transistor MP10 will conduct only when the level at INPUT_ 1 is at least one diode voltage above DVDD. Accordingly, the voltage level at node A is limited to DVDD plus one diode voltage.

For a proper operation of the circuit, transistor MP1 must start conducting before transistor MP0. This condition is satisfied by an appropriate sizing ratio on the chip die between transistors MP1 and MP0.

Those skilled in the art to which the invention relates will appreciate that the foregoing example implementation is but one of the many implementations that may be employed within the scope of the claimed invention.

## Claims

1. An integrated circuit for operation at a specified maximum supply voltage, comprising:
first (DVDD) and second (DVSS) voltage supply terminals;
a first signal input for application of a regular input signal (INPUT_1);
a second signal input (INPUT_2);
an output (OUT);
a multiplexers (MUX) with first (A) and seconds (B) inputs respectively coupled to the first and second signal inputs, for selectively switching either of the first and second signal inputs to the output under control of a selection signal;
a gate circuit (GATE) providing the selection signal to the multiplexer;
clamping circuitry (RO, MPO) connected to limit the voltage at the first input of the multiplexer; and
control circuitry (MN6, MN8, MP1, MP10, R5, R8, R9, R10) connected and configured to detect a voltage at the first signal input that exceeds a maximum supply voltage by a given amount and for driving an input (N3) of said gate circuit in response thereto.

2. The integrated circuit of claim 1, wherein the clamping circuitry comprises a first resistor connected between the first signal input and the first input of the multiplexer, and a diode-connected first MOS transistor connected between the first input of the multiplexer and the first voltage supply terminal.

3. The integrated circuit of claim 1 or claim 2, wherein the control circuitry comprises an MOS transistor and a resistive divider, the channel of the second MOS transistor being connected in series with the resistive divider between the first input of the multiplexer and the second voltage supply terminal; the resistive divider having a node connected to the input of the gate circuit; and the MOS transistor having a gate controlled by biasing circuitry.

4. The integrated circuit of claim 3, wherein the biasing circuitry includes a diode-connected MOS transistor connected between the first voltage supply terminal and the gate of the MOS transistor, and a second resistor and second MOS transistor having a channel connected in series with the second resistor between the gate of the MOS transistor and the second voltage supply terminal (DVSS) and a gate connected to the node of the resistive divider.

5. The integrated circuit of claim 3 or claim 4, wherein the second MOS transistor is dimensioned substantially larger than the diode-connected first MOS transistor.

## Patentansprüche

1. Integrierte Schaltung für den Betrieb bei einer festgelegten maximalen Versorgungsspannung, mit:
einem ersten (DVDD) und einem zweiten (DVSS) Versorgungsspannungsanschluss;
einem ersten Signaleingang für das Anlegen eines regulären Eingangssignals (INPUT_1);
einem zweiten Signaleingang (INPUT_2);
einem Ausgang (OUT);
einem Multiplexer (MUX) mit einem ersten (A) und einem zweiten (B) Eingang, der mit dem ersten bzw. mit dem zweiten Signaleingang verbunden ist, um unter Steuerung eines Auswahlsignals wahlweise den ersten oder den zweiten Signaleingang an den Ausgang umzuschalten;
einem Logikgatter (GATE), das dem Multiplexer das Auswahlsignal bereitstellt;
einer Begrenzerschaltung (RO, MPO), die so verbunden ist, dass sie die Spannung an dem ersten Eingangs des Multiplexers begrenzt; und
einer Steuerschaltung (MN6, MN8, MP1, MP10, R5, R8, R9, R10), die so verbunden und ausgelegt ist, dass sie eine Spannung am ersten Signaleingang detektiert, die eine maximale Versorgungsspannung um einen vorgegebenen Betrag überschreitet, und so, dass sie einen Eingang (N3) des Logikgatters in Antwort darauf ansteuert.

2. Integrierte Schaltung gemäß Anspruch 1, bei der die Begrenzerschaltung einen ersten Widerstand, der zwischen den ersten Signaleingang und den entsprechenden ersten Eingang des Multiplexers geschaltet ist, und einen als Diode geschalteten ersten MOS-Transistor umfasst, der zwischen den ersten Eingang des Multiplexers und den ersten Versorgungsspannungsanschluss geschaltet ist.

3. Integrierte Schaltung gemäß Anspruch 1 oder Anspruch 2, bei der die Steuerschaltung einen MOS-Transistor und einen Widerstandsteiler umfasst, wobei der Kanal des zweiten MOS-Transistors zwischen dem ersten Eingang des Multiplexers und dem zweiten Versorgungsspannungsanschluss in Reihe mit dem Widerstandsteiler geschaltet ist, der Widerstandsteiler einen Knoten aufweist, der mit dem Eingang des Logikgatters verbunden ist, und der MOS-Transistor ein Gate aufweist, das durch eine Schaltung zur Vorspannungserzeugung gesteuert ist.

4. Integrierte Schaltung gemäß Anspruch 3, bei der die Schaltung zur Vorspannungserzeugung einen als Diode geschalteten MOS-Transistor, der zwischen den ersten Versorgungsspannungsanschluss und das Gate des ersten MOS-Transistors geschaltet ist, und einen zweiten Widerstand und einen zweiten MOS-Transistor, der einen zwischen dem Gate des MOS-Transistors und dem zweiten Versorgungsspannungsanschluss (DVSS) in Reihe mit dem zweiten Widerstand geschalteten Kanal und ein mit dem Knoten des Widerstandsteiler verbundenes Gate aufweist, umfasst.

5. Integrierte Schaltung gemäß Anspruch 3 oder Anspruch 4, bei der der zweite MOS-Transistor wesentlich größer dimensioniert ist als der als Diode geschaltete erste MOS-Transistor.

## Revendications

1. Circuit intégré destiné à fonctionner à une tension d'alimentation maximale donnée, ledit circuit intégré comprenant :
une première (DVDD) et seconde (DVSS) bornes d'alimentation en tension ;
une première entrée de signaux destinée à appliquer un signal d'entrée normal (INPUT 1) ;
une seconde entrée de signaux (INPUT 2) ;
une sortie (OUT) ;
un multiplexeur (MUX) comportant une première (A) et une seconde (B) entrées respectivement couplées à la première et à la seconde entrées de signaux, afin de commuter sélectivement chacune des première et seconde entrées de signaux sur la sortie par commande d'un signal de sélection ;
un circuit de porte (GATE) transmettant le signal de sélection au multiplexeur ;
un circuit de verrouillage (RO, MPO) connecté pour limiter la tension au niveau de la première entrée du multiplexeur ; et
un circuit de commande (MN6, MN8, MP1, MP40, R5, R8, R9, R10) connecté et configuré pour détecter, au niveau de la première entrée de signaux, une tension supérieure d'une valeur déterminée à une tension d'alimentation maximale et pour exciter, en réponse, une entrée (N3) dudit circuit de porte.

2. Circuit intégré selon la revendication 1, dans lequel le circuit de verrouillage comprend une première résistance connectée entre la première entrée de signaux et la première entrée du multiplexeur et un premier transistor MOS connecté à une diode connecté entre la première entrée du multiplexeur et la première borne d'alimentation en tension.

3. Circuit intégré selon la revendication 1 ou la revendication 2, dans lequel le circuit de commande comprend un transistor MOS et un diviseur résistif, le canal du second transistor MOS étant connecté en série avec le diviseur résistif entre la première entrée du multiplexeur et la seconde borne d'alimentation en tension ; le diviseur résistif comportant un noeud connecté à l'entrée du circuit de porte ; et le transistor MOS comportant une porte commandée par un circuit de polarisation.

4. Circuit intégré selon la revendication 3, dans lequel le circuit de polarisation comprend un transistor MOS connecté à une diode connecté entre la première borne d'alimentation en tension et la porte du transistor MOS et une seconde résistance et un second transistor MOS dont un canal est connecté en série à la seconde résistance entre la porte du transistor MOS et la seconde borne d'alimentation en tension (DVSS) et une porte connectée au noeud du diviseur résistif.

5. Circuit intégré selon la revendication 3 ou la revendication 4, dans lequel le second transistor MOS est dimensionné de manière qu'il soit sensiblement plus grand que le premier transistor MOS connecté à une diode.
